(19)

Europäisches
Patentamt
European
Patent Office
Office européen
des brevets

(11)  **EP 4 567 445 A1**

(12)  **EUROPEAN PATENT APPLICATION**
published in accordance with Art. 153(4) EPC

(43)  Date of publication:
      **11.06.2025 Bulletin 2025/24**

(21)  Application number: **23849039.5**

(22)  Date of filing: **05.06.2023**

(51)  International Patent Classification (IPC):
      *G01R 31/388* (2019.01)      *G01R 31/396* (2019.01)
      *G01R 31/36* (2020.01)

(86)  International application number:
      **PCT/CN2023/098427**

(87)  International publication number:
      **WO 2024/027329 (08.02.2024 Gazette 2024/06)**

(84)  Designated Contracting States:
      **AL AT BE BG CH CY CZ DE DK EE ES FI FR GB
      GR HR HU IE IS IT LI LT LU LV MC ME MK MT NL
      NO PL PT RO RS SE SI SK SM TR**
      Designated Extension States:
      **BA**
      Designated Validation States:
      **KH MA MD TN**

(30)  Priority: **02.08.2022  CN 202210923233**

(71)  Applicant: **REPT BATTERO Energy Co., Ltd.
      Wenzhou, Zhejiang 325000 (CN)**

(72)  Inventors:
      • **CAO, Hui
        Wenzhou, Zhejiang 325000 (CN)**

• **SHEN, Xiangdong
  Shanghai 201206 (CN)**
• **FENG, Lihong
  Shanghai 201206 (CN)**
• **SHEN, Chengyu
  Shanghai 201206 (CN)**
• **HOU, Min
  Shanghai 201206 (CN)**
• **CAO, Kai
  Wenzhou, Zhejiang 325000 (CN)**
• **LIU, Jianyong
  Shanghai 201206 (CN)**

(74)  Representative: **Potter Clarkson
      Chapel Quarter
      Mount Street
      Nottingham NG1 6HQ (GB)**

(54)  **METHOD AND DEVICE FOR ESTIMATING STATE OF CHARGE OF BATTERY IN BATTERY
      SYSTEM**

(57)     A method and device for estimating the state of
charge of a battery in a battery system, the method
comprising: obtaining the state of charge of a replace-
ment module, and obtaining the state of charge of a main
circuit battery by means of the state of charge of the
replacement module, wherein the replacement module is
used to replace an original battery and the capacity of the
replacement module is greater than that of the original
battery, and the original battery is connected in series
with the main circuit battery in a lithium iron phosphate
battery branch of the battery system; conducting self-
discharge detection on the replacement module and the
main circuit battery, and carrying out balance control
when the replacement module or the main circuit battery
has a large amount of self-discharge; and after balance
control, determining an updated state of charge of the
replacement module, and updating the state of charge of
the main circuit battery according to the updated state of
charge of the replacement module.

Obtaining a state of charge of a replacement module, and obtaining a
state of charge of a main circuit battery by means of the state of charge of
the replacement module, wherein the replacement module is used to replace
an original battery and a capacity of the replacement module is greater than
a capacity of the original battery, and the original battery is connected in
series with the main circuit battery in a lithium iron phosphate battery
branch of the battery system

Conducting self-discharge detection on the replacement module and the
main circuit battery according to the state of charge and a state of health of
battery of the replacement module and the main circuit battery, respectively,
and performing balance control on the replacement module and the main
circuit battery when the replacement module or the main circuit battery has
a large amount of self-discharge

Determining an updated state of charge of the replacement module after
the balance control, and updating the state of charge of the main circuit
battery according to the updated state of charge of the replacement module

**FIG. 2**

EP 4 567 445 A1

**Description**

Technical Field

The present disclosure relates to battery technology, and in particular to a method and device for estimating the state of charge of a battery in a battery system.

Background

The Chinese invention patent document with the publication number CN114545256A discloses a method and system for estimating the state of charge of a lithium iron phosphate battery, in which a replacement module with a larger capacity than the main circuit battery is used to replace one of the original batteries in the main circuit, and the state of charge of the replacement module is noted as X. Firstly, the state of charge of the battery in the replacement module and the main circuit is adjusted so that the two are consistent at 0% SOC, and according to the series relationship, in the subsequent charging and discharging process, the estimated state of charge of the main circuit is X*A/B, wherein the A is the capacity of the replacement module, and the B is the capacity of the battery in the main circuit. According to the charging and discharging voltage curve characteristics of iron lithium battery, the battery voltage varies more obviously with the state of charge in the interval of 0%~30% SOC and the interval of 90% ~100% SOC, which can be used to estimate the state of charge.

The above technical solution, although it enlarges the estimation interval of the state of charge of the main circuit, when there is a large amount of self-discharge in the replacement module or among the main circuit batteries, it will cause a large error in the estimation of the state of charge, which in turn will cause an inaccurate estimation result of the state of charge of the lithium iron phosphate battery.

Summary

In view of the disadvantages of the prior art mentioned above, the purpose of the present disclosure is to provide a method and device for estimating the state of charge of a battery in a battery system, which solves the problem of inaccurate estimation result of the state of charge of the lithium iron phosphate battery in the prior art.

In order to realize the above and other related purposes, the present disclosure provides a method for estimating a state of charge of a battery in a battery system, wherein comprising at least the following steps:

Using a replacement module with a larger capacity than the original battery to replace an original battery, wherein the lithium iron phosphate battery branch of the battery system consists of the original battery and the main circuit battery connected in series;
Obtaining a state of charge of the replacement module, and obtaining a state of charge of the main circuit battery by means of the state of charge of the replacement module;
Conducting self-discharge detection on the replacement module and the main circuit battery according to the state of charge and a state of health of battery of the replacement module and the main circuit battery, respectively, and performing balance control on the replacement module and the main circuit battery when the replacement module or the main circuit battery has a large amount of self-discharge;
Determining an updated state of charge of the replacement module after the balance control, and updating the state of charge of the main circuit battery according to the updated state of charge of the replacement module.

Preferably, conducting self-discharge detection on the replacement module and the main circuit battery according to the state of charge of the replacement module and the main circuit battery, respectively, comprises:
Conducting self-discharge detection when both the state of charge of the replacement module and the state of charge of the main circuit battery are in an interval of low state of charge or when the state of charge of the main circuit battery is in an interval of high state of charge.

Preferably, the interval of low state of charge is 0%~30%, and the interval of high state of charge is 90% ~100%.

Preferably, the performing balance control on the replacement module and the main circuit battery comprises: transferring a portion of a battery energy with a small amount of self-discharge in the replacement module or the main circuit battery to a battery with a large amount of self-discharge.

Preferably, the performing balance control on the replacement module and the main circuit battery comprises: consuming a battery energy with a small amount of self-discharge in the replacement module or the main circuit battery through resistance.

Preferably, using a proportional conversion method to estimate and obtain the state of charge of the main circuit battery according to the state of charge or the updated state of charge of the replacement module.

Preferably, before the conducting self-discharge detection on the replacement module and the main circuit battery according to the state of charge and a state of health of battery of the replacement module and the main circuit battery, respectively, further comprises:
Determining a state of health of battery of the replacement module and a state of health of battery of the main circuit battery.

Determining a current capacity of the replacement module using the state of health of battery of the replacement module, and determining a current capacity of the main circuit battery using the state of health of battery of the main circuit battery.

Preferably, in the self-discharge detection, determining that a large amount of self-discharge occurs in the replacement module or the main circuit battery if the state of charge of the main circuit battery is not equal to n times the state of charge of the replacement module; wherein the n is the ratio of the current capacity of the replacement module to the current capacity C2 of the main circuit battery, wherein the current capacity of the replacement module is a product of an original capacity of the replacement module and the state of health of battery of the replacement module, and the current capacity of the main circuit battery is a product of an original capacity of the main circuit battery and the state of health of battery of the main circuit battery.

Preferably, a result of the balance control makes the state of charge of the main circuit battery equal to n times the state of charge of the replacement module.

In order to achieve the above purpose and other related purposes, the present disclosure also provides a device for estimating a state of charge of a battery in a battery system, wherein comprising a memory, a processor, and a program stored in the memory and runnable on the processor, wherein the processor executing the program to implement the steps of the method for estimating a state of charge of a battery in a battery system as described above.

As described above, the method and device for estimating the state of charge of a battery in a battery system of the present disclosure have the following beneficial effects:

The method for estimating the state of charge of a battery in a battery system of the present disclosure carries out self-discharge detection and balance control on the existing estimated state of charge, the state of charge of the main circuit battery is estimated and obtained by the updated state of charge after the balance control, avoids the interference caused by the large amount of self-discharge of the replacement module or the main circuit battery, improves the accuracy of the estimation of the state of charge of the main circuit battery, and also expands the estimation interval of the state of charge SOC of the main circuit battery, which further improves the stability of the battery system.

Brief Description of the Drawings

The features and performance of the present disclosure are further described by the following embodiments and the accompanying drawings.

FIG. 1 shows a schematic diagram of the variation of the charging voltage curve of a lithium iron phosphate battery in the present disclosure.

FIG. 2 shows a flow diagram of a method for estimating the state of charge of a battery in a battery system of the present disclosure.

FIG. 3 shows a schematic diagram of the structure of a device for estimating the state of charge of a battery in a battery system of the present disclosure.

Preferred Embodiment of the Present Disclosure

Embodiments of the present disclosure are described below by way of particular specific examples, and other advantages and effects of the present disclosure can be readily understood by the person skilled in the art from the contents disclosed in the specification. The present disclosure may also be implemented or applied in various other specific embodiments, and various details in the specification may also be modified or altered based on different viewpoints and applications without departing from the spirit of the present disclosure.

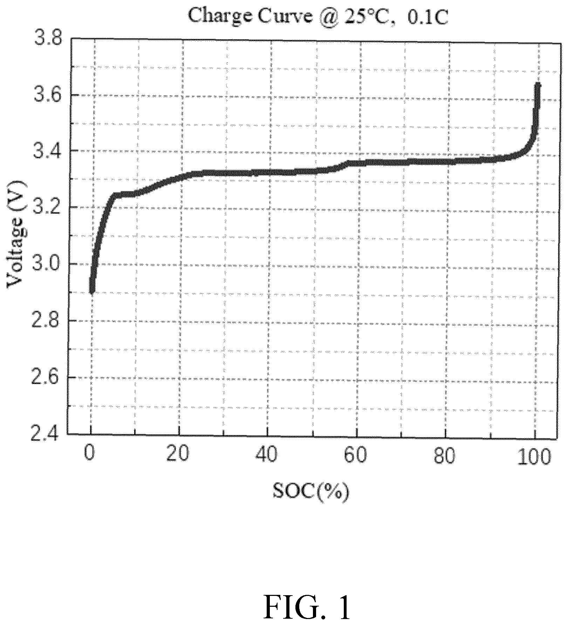

Please refer to FIG. 1 to FIG. 3. It should be noted that the drawings provided in the embodiment only illustrate the basic concept of the present disclosure in a schematic manner. Therefore, the drawings only show the components related to the present disclosure and are not drawn according to the number, the shape, and the size of the components in actual implementation. The form, the number, and the proportion of each component in actual implementation can be an arbitrary change, and the layout of the components may also be more complex.

As shown in FIG. 1, it is a schematic diagram of the variation of 0.1C charging voltage curve of a lithium iron phosphate battery at 25°C. According to FIG. 1, it can be seen that the variation of voltage with SOC is not obvious in the interval of state of charge 30%~90% SOC, which increases the difficulty of SOC estimation; while in the detection interval of the state of charge 0%~30% SOC and 90%~100% SOC, the variation of voltage with the state of charge is more obvious. Therefore, the estimation of the state of charge can be carried out by voltage characteristics in the two intervals, and the estimation result is more accurate.

The present disclosure, in order to solve the technical defect of the prior art that when there is a large amount of self-discharge in the replacement module or the main circuit batteries, it will cause a large error in the estimation of the state of charge, which will further lead to an inaccurate estimation result of the state of charge of the lithium iron phosphate battery. The present disclosure proposes to add the means of the self-discharge detection and the balance control in the case of low state of charge (i.e., the state of charge of the replacement module and the state of charge of the main circuit battery are both less than 30%) and in the case of high state of charge (i.e., the state of charge of the main circuit battery is greater than 90%), thereby improving the accuracy of estimation of the state of charge of the lithium iron phosphate battery and expanding the estimation interval of the state of charge of the lithium iron phosphate battery, and further improving the stability of the battery system.

Method Embodiment:

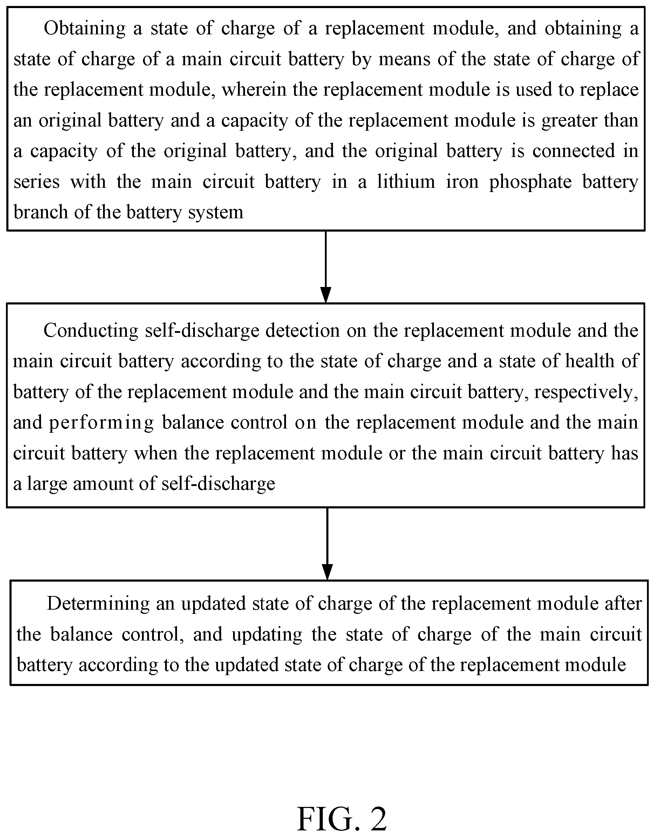

The present disclosure proposes a method for estimating a state of charge of a battery in a battery system, as shown in FIG. 2, comprising at least:
In the embodiment of the present disclosure, the original capacity of the replacement module is C1' and the original capacity of the main circuit battery is C2', wherein C1'/C2'> 1.

S1, obtaining a state of charge of a replacement module, and obtaining a state of charge of a main circuit battery by means of the state of charge of the replacement module, wherein the replacement module is used to replace an original battery and a capacity of the replacement module is greater than a capacity of the original battery, and the original battery is connected in series with the main circuit battery in a lithium iron phosphate battery branch of the battery system.

In the lithium iron phosphate battery branch of the battery system of the present disclosure, the original battery and the main circuit battery are identical.

The replacement module of the present disclosure is a replacement battery, and the replacement battery may be a lithium iron phosphate battery with greater difference than the original battery capacity and higher capacity than the original battery.

The present disclosure uses a proportional conversion method to estimate and obtain the state of charge of the main circuit battery according to the state of charge of the replacement battery. Specifically, converting the state of charge of the replacement battery to the state of charge of the main circuit battery using the proportional conversion method. In this case, the larger the difference between the capacity of the replacement battery and the capacity of the main circuit battery, the wider the interval segment for estimating the state of charge. Then, the larger the difference between the capacity of the replacement battery and the capacity of the main circuit battery, the more accurate the estimation will be, but if the difference is too large, it will lead to a waste of cost, which makes it impossible to be applied in practice.

In the embodiment of the present disclosure, the number of the original battery and the number of the replacement battery in the replacement module are not limited, and the number of the original battery and the number of the replacement battery in the replacement module may be the same or different. The number may be one or multiple, but when the number is multiple, the multiple original batteries may be connected in series or parallel, and the replacement batteries in the replacement module may be connected in series or parallel, as long as it is satisfied that the capacity of the battery in the replacement module is larger than the capacity of the original battery.

The present disclosure uses the proportional conversion method to estimate and obtain the state of charge of the main circuit battery according to the state of charge of the replacement battery. Therefore, it is necessary to first obtain the state of charge of the replacement module and determine the proportional conversion method.

In the present disclosure, the state of charge of the replacement module and the state of charge of the main circuit battery are consistent at 0% SOC. According to the series relationship, in the subsequent charging and discharging process, the relationship between the state of charge SOC_X of the main circuit battery and the state of charge SOC_T of the replacement module is shown as:

$$\mathrm{SOC\_X = n` \times SOC\_T}$$

Wherein, the coefficient n' is the ratio of the original capacity C1' of the replacement module to the original capacity C2' of the main circuit battery, i.e., n'=C1'/C2'.

In the embodiment of the present disclosure, the state of charge of the replacement module is obtained by estimating the state of charge according to the voltage, the state of charge of the replacement module is SOC_T, and the state of charge of the main circuit battery is SOC_X=SOC_T$\times$ (C1'/C2').

In the embodiment of the present disclosure, taking n'=2 as an example, the replacement module is the lithium iron phosphate battery, and the original capacity C1' of the replacement battery is twice the original capacity C2' of the main circuit battery. As other embodiments, the n' may also be a value of 1.5, 3, 4, etc.

In the initial state, both the replacement battery and the main circuit battery are in the 0% SOC state. Since the two are connected in series, the subsequent charging and discharging process flow the same current through the two, so when the state of charge of the main circuit battery varies in 0%~100%, the state of charge of the replacement battery is just half of the state of charge of the main circuit battery, i.e., 0%~50%. In the more accurate detection interval of the SOC of the replacement battery, such as the 0%~30% state of charge detection interval of the lithium iron phosphate battery, the SOC of the replacement battery can be estimated more accurately by the voltage and the SOC (0%~60% SOC) of the main circuit battery can be obtained. In other intervals (e.g., the 90%~100% SOC interval of the lithium iron phosphate battery), the estimated SOC of the main circuit battery is still used.

Therefore, when the state of charge SOC_T of the replacement battery is at 0%~30% SOC, the state of charge SOC_X of the main circuit battery is 2$\times$ SOC_T and is estimated more accurately. At this time, the state of charge of the main circuit battery at 0%~60% SOC can be estimated accurately, while the 90%~100% SOC interval segment is still estimated by using the voltage of the main circuit for the SOC estimation. Therefore, the embodiment of the present disclosure can extend the accurate segment of the state of charge estimated by the voltage from 0%~30%SOC and 90%~100%SOC to 0%~60% SOC and 90%~100%SOC. The embodiment of the present disclosure is only used as an example and is not limited to it.

S2, conducting self-discharge detection on the replacement module and the main circuit battery according to the state of charge of the replacement module and the state of charge of the main circuit battery, respectively, and when there is a large amount of self-discharge in the replacement module or the main circuit battery, performing balance control on the replacement module and the main circuit battery.

Since the theoretical state of charge of the replacement module and the state of charge of the main circuit battery remains the same at 0% SOC, at this time, it is considered that the state of health of the replacement module is SOH1 and the state of health of the main circuit battery is SOH2, and SOH1/SOH=1. According to the series relationship, in the subsequent charging and discharging process, the relationship between the state of charge SOC_X of the main circuit battery and the state of charge SOC_T of the replacement module is shown as:

$$SOC\_X = n` \times SOC\_T$$

However, in practice, the phenomenon of large amount of self-discharge occurs due to the influence of some losses or other factors, which in turn leads to the subsequent charging and discharging process does not necessarily maintain the relationship of SOC_X=n' $\times$ SOC_T. When the relationship of the state of charge cannot be maintained, the result of the state of charge estimated by the method may generates a large error, and therefore, it is necessary to carry out self-discharge detection and balance control of the replacement module and the main circuit battery, so as to ensure the accuracy of the SOC estimation of the state of charge of the main circuit battery.

In addition, since a change in the state of health of the battery causes a change in the coefficient n', it is necessary to re-determine the relationship between the state of charge SOC_X of the main circuit battery and the state of charge SOC_T of the replacement module as:

$$SOC\_X = n \times SOC\_T$$

Wherein the n is the ratio of the current capacity C1 of the replacement module to the current capacity of the main circuit battery, i.e., n=C1/C2. Wherein the current capacity of the replacement module is the product of the original capacity C1' of the replacement module and the state of health of battery SOH1 of the replacement module, and the current capacity of the main circuit battery is the product of the original capacity C2' of the main circuit battery and the state of health of battery SOH2 of the main circuit battery, wherein C1'> C2'.
It should be noted that SOH1/SOH2 = 1 at the initial moment, at this time, the n is equal to the n' at the initial moment.

The present disclosure updates the current capacity of the replacement module and the current capacity of the main circuit battery by the state of health of battery, then re-determines a new equilibrium relationship between the state of charge of the main circuit battery and the state of charge of the replacement module, and finally determines according to the new equilibrium relationship, which improves the accuracy of the determination of large amount of self-discharge.

Since conducting self-discharge detection on the replacement module and the main circuit battery according to the state of charge and the state of health of battery of the replacement module and the main circuit battery, respectively, so that before conducting the self-discharge detection further comprises:
Determining the state of health of battery of the replacement module and the state of health of battery of the main circuit battery.

Determining the current capacity of the replacement module using the state of health of battery of the replacement module, and determining the current capacity of the main circuit battery using the state of health of battery of the main circuit battery.

Wherein the method of determining and obtaining the state of health of battery is prior art and will not be discussed in detail in the embodiment of the present disclosure.

In a possible embodiment, when both the state of charge of the replacement module and the state of charge of the main circuit battery are in an interval of low state of charge or when the state of charge of the main circuit battery is in an interval of high state of charge, conducting self-discharge detection and carrying out balance control to the large amount of self-discharge.

In embodiment of the present disclosure, the interval of low state of charge is 0%~30%, and the interval of high state of charge is 90%~100%.

In the self-discharge detection process, the state of charge of the replacement module is estimated and obtained according to the voltage of the replacement module or the ampere-time integration method, and the state of charge of the main circuit battery is estimated and obtained according to the voltage of the main circuit battery.

When both the state of charge of the replacement module and the state of charge of the main circuit battery are in the interval of low state of charge (0% ~30%), conducting the self-discharge detection and determining whether the replacement module or the main circuit battery has a large amount of self-discharge.

Specifically, the state of charge SOC_X of the main circuit battery estimated according to the voltage is less than 30%, and the state of charge SOC_T of the replacement module estimated according to the voltage is less than 30%.

If SOC_X>n×SOC_T, then it is determined that a large amount of self-discharge has occurred in the replacement module. If SOC_X<n×SOC_T, then it is determined that a large amount of self-discharge has occurred in the main circuit battery.

If SOC_X=n×SOC_T, neither the replacement module nor the main circuit battery are experiencing the phenomenon of large amount of self-discharge.

When the state of charge of the main circuit battery is in the interval of high state of charge (90% ~100%), conducting the self-discharge detection and determining whether the replacement module or the main circuit battery has a large amount of self-discharge.

Specifically, the state of charge SOC_X of the main circuit battery estimated according to the voltage is greater than 90% and the state of charge of the replacement module is less than 50%.

If SOC_X>n×SOC_T, then it is determined that a large amount of self-discharge has occurred in the replacement module. If SOC_X <n×SOC_T, then it is determined that a large amount of self-discharge has occurred in the main circuit battery.

If SOC_X=n×SOC_T, neither the replacement module nor the main circuit battery are experiencing the phenomenon of large amount of self-discharge.

According to the characteristic curve of the voltage and the state of charge, it can be seen that the variation of the voltage with the SOC is not obvious between 30%~60%, so the estimation of the SOC according to the voltage may be prone to a large deviation, and therefore, the state of charge can be estimated and obtained according to other methods in the prior art, such as the ampere-time integration method.

According to the self-discharge detection of the presence of the phenomenon of large amount of self-discharge, the balance control is carried out to make SOC_X=n×SOC_T again to ensure the accuracy of the subsequent estimation of the state of charge of the main circuit battery.

In another preferred embodiment of the present disclosure, it is considered that the absolute balance cannot be stably maintained during the balance control process, therefore, in practical application, based on the determination condition in the embodiments of the present disclosure, a certain degree of deviation can be allowed to determine the existence of large amount of self-discharge, wherein the deviation can be the magnitude of the deviation (single value or interval), or a certain proportional value.

Specifically, for example, whether in the interval of low state of charge or the interval of high state of charge, if SOC_X> n × SOC_T+ δ, then it is determined that a large amount of self-discharge has occurred in the replacement module. If SOC_X<n×SOC_T- δ, then it is determined that a large amount of self-discharge has occurred in the main circuit battery. If SOC_X=n×-SOC_T± δ, then it is determined that neither the replacement module nor the main circuit battery are experiencing the phenomenon of large amount of self-discharge. Wherein the δ denotes the magnitude of the deviation. The embodiment of the present disclosure does not make specific limitations on the specific value or interval of δ, etc., which can be selected according to the actual situation.

In embodiment of the present disclosure, when the replacement module or the main circuit battery has a large amount of self-discharge, it indicates that the other has a small amount of self-discharge. The balance control of the present disclosure is either active balance or passive balance. The active balance means transferring a portion of the battery energy with a small amount of self-discharge in the replacement module or the main circuit battery to a battery with a large amount of self-discharge, and the passive balance means consuming the battery energy with a small amount of self-discharge in the replacement module or the main circuit battery through resistance.

The present disclosure readjusts the relationship between the state of charge of the replacement module and the state of charge of the main circuit battery by balance control, thereby ensuring the accuracy of the state of charge of the main circuit battery obtained according to the updated state of charge of the replacement module.

S3, determining the updated state of charge of the replacement module after the balance control, and updating the state of charge of the main circuit battery according to the updated state of charge of the replacement module.

After carrying out balance control to the battery in the lithium iron phosphate battery branch of the battery system, the updated state of charge of the replacement module is determined. Then, the method of step S1 is adopted, i.e., using a proportional conversion method to estimate and obtain the updated state of charge of the main circuit battery according to the updated state of charge of the replacement module. By updating the state of charge of the main circuit battery through the updated state of charge of the main circuit battery, a more accurate state of charge of the main circuit is obtained.

Wherein the updated state of charge the replacement module is determined as follows: when the state of charge of the replacement module is not changed during the balance control process, the updated state of charge is the original state of charge, and when the state of charge of the replacement module is changed during the balance control process, it is necessary to reacquire or calculate the state of charge of the replacement module to determine the updated state of charge. However, in practice, if the time of the balance control is a little long, the state of charge of the replacement module will be changed regardless of whether it is used as the controlled balance object, and at this time, the updated state of charge the replacement module is always the state of charge to be reacquired.

Specifically, the updated state of charge of the main circuit battery is estimated and obtained using a proportional conversion method according to the updated state of charge of the replacement module, the updated state of charge of the main circuit battery is used as the state of charge of the main circuit battery, and the state of charge of the main circuit battery is estimated and obtained by the updated state of charge after the balance control. The method avoids interference caused by the large amount of self-discharge in the replacement module or the main circuit battery, improves the accuracy of estimating the state of charge of the main circuit battery, expands the estimation interval of the state of charge SOC of the main circuit battery, and further improves the stability of the battery system.

Device Embodiment:

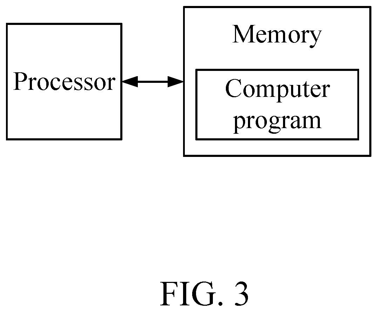

The present disclosure also provides a schematic diagram of the structure of a device for estimating the state of charge of a battery in a battery system as shown in FIG. 3, wherein comprising the memory, the processor, and the program stored in the memory and runnable on the processor, wherein the processor executing the program to implement the steps of the method for estimating a state of charge of a battery in a battery system as described above.

The detailed process of the steps of the method for estimating a state of charge of a battery in a battery system is described in detail in the Method Embodiment and will not be repeated here.

In summary, the present disclosure comprises the method and device for estimating the state of charge of a battery in a battery system, wherein the method for estimating a state of charge of a battery in a battery system carries out the self-discharge detection and the balance control of the existing estimated state of charge, and the state of charge of the main circuit battery is estimated and obtained by the updated state of charge after the balance control, avoids interference caused by the large amount of self-discharge in the replacement module or the main circuit battery, further improves the accuracy of estimating the state of charge of the main circuit battery, also expands the estimation interval of the state of charge SOC of the main circuit battery, and further improves the stability of the battery system. Therefore, the present disclosure effectively overcomes the shortcomings of the prior art and has high industrial utilization value.

The above embodiments are merely illustrative of the principles and its efficacy of the present disclosure, and are not intended to limit the present disclosure. Any person skilled in the art may modify or change the above embodiments without violating the spirit and scope of the present disclosure. Therefore, all equivalent modifications or alterations made by a person having ordinary knowledge in the art without departing from the spirit and technical ideas disclosed in the present disclosure shall still be covered by the claims of the present disclosure.

**Claims**

1. A method for estimating a state of charge of a battery in a battery system, wherein comprising at least the following steps:

   obtaining a state of charge of a replacement module, and obtaining a state of charge of a main circuit battery by means of the state of charge of the replacement module, wherein the replacement module is used to replace an original battery and a capacity of the replacement module is greater than a capacity of the original battery, and the original battery is connected in series with the main circuit battery in a lithium iron phosphate battery branch of the battery system;
   conducting self-discharge detection on the replacement module and the main circuit battery according to the state of charge and a state of health of battery of the replacement module and the main circuit battery, respectively, and performing balance control on the replacement module and the main circuit battery when the replacement module or the main circuit battery has a large amount of self-discharge;
   determining an updated state of charge of the replacement module after the balance control, and updating the state of charge of the main circuit battery according to the updated state of charge of the replacement module.

2. The method for estimating a state of charge of a battery in a battery system according to claim 1, wherein conducting self-discharge detection on the replacement module and the main circuit battery according to the state of charge of the replacement module and the main circuit battery, respectively, comprises:
   conducting self-discharge detection when both the state of charge of the replacement module and the state of charge of the main circuit battery are in an interval of low state of charge or when the state of charge of the main circuit battery is in an interval of high state of charge.

3. The method for estimating a state of charge of a battery in a battery system according to claim 2, wherein the interval of low state of charge is 0%~30%, and the interval of high state of charge is 90%~100%.

4. The method for estimating a state of charge of a battery in a battery system according to claim 1, wherein the performing balance control on the replacement module and the main circuit battery comprises: transferring a portion of a battery energy with a small amount of self-discharge in the replacement module or the main circuit battery to a battery with a large amount of self-discharge.

5. The method for estimating a state of charge of a battery in a battery system according to claim 1, wherein the performing balance control on the replacement module and the main circuit battery comprises: consuming a battery energy with a small amount of self-discharge in the replacement module or the main circuit battery through resistance.

6. The method for estimating a state of charge of a battery in a battery system according to claim 1, wherein using a proportional conversion method to estimate and obtain the state of charge of the main circuit battery according to the state of charge or the updated state of charge of the replacement module.

7. The method for estimating a state of charge of a battery in a battery system according to claim 1, wherein before the conducting self-discharge detection on the replacement module and the main circuit battery according to the state of charge and a state of health of battery of the replacement module and the main circuit battery, respectively, further comprises:

determining a state of health of battery of the replacement module and a state of health of battery of the main circuit battery; determining a current capacity of the replacement module using the state of health of battery of the replacement module, and determining a current capacity of the main circuit battery using the state of health of battery of the main circuit battery.

8. The method for estimating a state of charge of a battery in a battery system according to claim 7, wherein in the self-discharge detection, determining that a large amount of self-discharge occurs in the replacement module or the main circuit battery if the state of charge of the main circuit battery is not equal to n times the state of charge of the replacement module; wherein the n is the ratio of the current capacity of the replacement module to the current capacity of the main circuit battery, wherein the current capacity of the replacement module is a product of an original capacity of the replacement module and the state of health of battery of the replacement module, and the current capacity of the main circuit battery is a product of an original capacity of the main circuit battery and the state of health of battery of the main circuit battery.

9. The method for estimating a state of charge of a battery in a battery system according to claim 8, wherein a result of the balance control makes the state of charge of the main circuit battery equal to n times the state of charge of the replacement module.

10. A device for estimating a state of charge of a battery in a battery system, wherein comprising a memory, a processor, and a program stored in the memory and runnable on the processor, wherein the processor executing the program to implement the steps of the method for estimating a state of charge of a battery in a battery system of any one of claims 1-9.

FIG. 1

Obtaining a state of charge of a replacement module, and obtaining a state of charge of a main circuit battery by means of the state of charge of the replacement module, wherein the replacement module is used to replace an original battery and a capacity of the replacement module is greater than a capacity of the original battery, and the original battery is connected in series with the main circuit battery in a lithium iron phosphate battery branch of the battery system

Conducting self-discharge detection on the replacement module and the main circuit battery according to the state of charge and a state of health of battery of the replacement module and the main circuit battery, respectively, and performing balance control on the replacement module and the main circuit battery when the replacement module or the main circuit battery has a large amount of self-discharge

Determining an updated state of charge of the replacement module after the balance control, and updating the state of charge of the main circuit battery according to the updated state of charge of the replacement module

## FIG. 2

FIG. 3

## INTERNATIONAL SEARCH REPORT

| International application No. |
| --- |
| **PCT/CN2023/098427** |

### A. CLASSIFICATION OF SUBJECT MATTER

G01R31/388(2019.01)i; G01R31/396(2019.01)i; G01R31/36(2020.01)i

According to International Patent Classification (IPC) or to both national classification and IPC

### B. FIELDS SEARCHED

Minimum documentation searched (classification system followed by classification symbols)

IPC:G01R

Documentation searched other than minimum documentation to the extent that such documents are included in the fields searched

Electronic data base consulted during the international search (name of data base and, where practicable, search terms used)

CNTXT; CNKI; CJFD; WPABS; ENTXT; ENTXTC; IEEE: 瑞浦兰钧, 曹辉, 沈向东, 冯礼鸿, 沈成宇, 候敏, 曹楷, 刘建永, 自放电, 均衡, 精度, 准确性, 准确度, 荷电状态, 剩余容量, 剩余电量, 当前电量, 荷电量, 残余电量, 残存电量, soc, state of charge, self discharg+, balanc+, equaliz+

### C. DOCUMENTS CONSIDERED TO BE RELEVANT

| Category* | Citation of document, with indication, where appropriate, of the relevant passages | Relevant to claim No. |
| --- | --- | --- |
| PX | CN 115343640 A (RUIPU LANJUN ENERGY CO., LTD.) 15 November 2022 (2022-11-15) claims 1-10 | 1-10 |
| A | CN 114545256 A (SHANGHAI RUPU GREEN INNOVATIVE ENERGY CO., LTD.) 27 May 2022 (2022-05-27) description, paragraphs [0048] and [0049], and figures 1 and 2 | 1-10 |
| A | CN 102088118 A (SHENZHEN HANGSHENG ELECTRONICS CO., LTD.) 08 June 2011 (2011-06-08) entire document | 1-10 |
| A | CN 106443480 A (TIANJIN EV ENERGIES CO., LTD.) 22 February 2017 (2017-02-22) entire document | 1-10 |
| A | JP 2005253287 A (DENSO CORP.) 15 September 2005 (2005-09-15) entire document | 1-10 |

☐ Further documents are listed in the continuation of Box C.　　☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **31 August 2023** | **10 September 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/098427**

| Patent document cited in search report | | | Publication date (day/month/year) | Patent family member(s) | | | Publication date (day/month/year) |
|---|---|---|---|---|---|---|---|
| CN | 115343640 | A | 15 November 2022 | None | | | |
| CN | 114545256 | A | 27 May 2022 | None | | | |
| CN | 102088118 | A | 08 June 2011 | CN | 102088118 | B | 18 September 2013 |
| CN | 106443480 | A | 22 February 2017 | None | | | |
| JP | 2005253287 | A | 15 September 2005 | JP | 4089691 | B2 | 28 May 2008 |

Form PCT/ISA/210 (patent family annex) (July 2022)

**EP 4 567 445 A1**

**Patent documents cited in the description**

- CN 114545256 A